# FASCICULE DE BREVET EUROPEEN

(11) **EP 0 420 752 B1**
(45) Date de publication et mention de la délivrance du brevet: **22.06.1994**
(21) Numéro de dépôt: 90402662.2
(22) Date de dépôt: 27.09.1990
(51) Int. Cl.: H03K 19/177, G11C 17/14

(54) **Réseau logique programmable intégré**
Integrierte, programmierbare Logikanordnung
Integrated programmable logic array

(30) Priorité: 28.09.1989 FR 8912679
(43) Date de publication de la demande: 03.04.1991
(73) Titulaire: BULL S.A., 92800 Puteaux (FR)
(72) Inventeur: Neu, Georges, F-75116 Paris (FR)
(74) Mandataire: Denis, Hervé

(56) Documents cités:
- EP-A- 0 116 287
- US-A- 4 409 499
- US-A- 4 725 745
- IBM TECHNICAL DISCLOSURE BULLETIN vol. 24, no. 5, octobre 1981, pages 2424,2425, new York, US; T. WINLOW: "Reloadable Programmable Logic Array"
- IBM TECHNICAL DISCLOSURE BULLETIN vol. 17, no. 10, mars 1975, pages 2957,2958, New York, US; G.J. KELLY et al. "Dual-Gate Programmable Logic Array"
- IBM TECHNICAL DISCLOSURE BULLETIN vol. 26, no. 11, avril 1984, pages 5835-5837, New York, US; M. CASES et al.: "CMOS Programmable Logic Array"
- VLSI DESIGN décembre 1983, pages 56-63; J.A. SUTTON: "The 80C86 CMOS Design From the nMOS Architecture"

## Description

L'invention a pour objet un réseau logique programmable intégré, comprenant des lignes d'entrée se croisant avec des lignes de sortie par l'intermédiaire de points de programmation. L'invention concerne les réseaux logiques dont les points de programmation comprennent chacun un transistor à effet de champ, tel qu'un transistor MOS (Metal Oxyde Semiconducteur) par exemple. Plus précisément, dans un point de programmation entre une ligne d'entrée et une ligne de sortie du réseau, le transistor à effet de champ a sa grille et son drain respectivement connectés à la ligne d'entrée et à la ligne de sortie et a sa source reliée à un potentiel de référence, la masse par exemple. Les réseaux logiques programmables intégrés visés par l'invention sont les circuits PLA (Programmable Logic Array) et les mémoires mortes ou mémoires ROM (Read Only Memory).

Les recherches actuelles dans le domaine des circuits PLA visent à accroître leur rapidité de fonctionnement. Une solution adoptée consiste à associer des transistors bipolaires aux transistors à effet de champ du réseau logique. La technologie correspondant à cette solution est couramment appelée BiMOS, ou BiCMOS dans un environnement CMOS (Complementary MOS). De manière classique, un circuit PLA se compose essentiellement d'une matrice des produits logiques ou matrice ET, recevant les signaux d'entrée du circuit PLA, et d'une matrice des sommes logiques ou matrice OU, recevant les signaux de sortie de la matrice ET et délivrant les signaux de sortie du circuit PLA. Selon un procédé connu, chaque point de programmation de la matrice ET est fait d'un transistor à effet de champ monté comme indiqué plus haut, tandis que chaque point de programmation de la matrice OU est fait d'un transistor bipolaire pourvu d'une pluralité de collecteurs égale à la pluralité des lignes de sortie du circuit PLA conformément à la technologie IIL (Integrated Injection Logic). Un tel circuit PLA est par exemple connu du document US-A-4 725 745.

Ce circuit PLA BiMos a l'avantage d'être très dense. Cependant, les transistors bipolaires qui assurent une plus grande rapidité du circuit PLA sont exclusivement concentrés dans la matrice de sortie du circuit PLA, à savoir la matrice OU. En outre, un courant statique est présent dans un circuit de type IIL. Le gain en rapidité du circuit PLA BiMOS n'est donc amélioré que très faiblement. D'autre part, le dimensionnement du transistor à effet de champ dans chaque point de programmation de la matrice d'entrée pose un problème difficile. En théorie, un fonctionnement rapide exige une grande taille du transistor à effet de champ. Mais un transistor de grande taille présente une capacité d'autant plus élevée. Une matrice faite de grands transistors à effet de champ présenterait donc un ensemble de fortes capacités montées en parallèle entre la masse et chaque ligne d'entrée, et entre la masse et chaque ligne de sortie. La somme de ces fortes capacités produirait un fort ralentissement de la commutation des lignes d'entrée et de la décharge des lignes de sortie. En conclusion, la présence de grands transistors à effet de champ dans un réseau logique programmable fait perdre leur rapidité et leur densité. Cela explique qu'en pratique un réseau logique programmable classique est fait de petits transistors à effet de champ qui lui donnent un fonctionnement relativement lent mais qui sauvegardent l'avantage d'une forte densité.

Le but de l'invention est de réaliser un réseau logique programmable intégré très rapide et ne consommant pas d'énergie statique, en exploitant au mieux les avantages de l'association de transistors bipolaires avec les transistors à effet de champ utilisés de manière classique.

Un réseau logique programmable intégré conforme à l'invention, comprenant des lignes d'entrée se croisant avec des lignes de sortie, un couplage pouvant être établi entre une ligne d'entrée et une ligne de sortie par l'intermédiaire de points de programmation incluant chacun un transistor à effet de champ ayant sa grille et son drain respectivement connectés à une ligne d'entrée et à une ligne de sortie et sa source reliée à un potentiel de référence, est caractérisé en ce que dans chaque point de programmation la source du premier transistor à effet de champ est reliée, d'une part, au potentiel de référence par l'intermédiaire du trajet drain-source d'un second transistor à effet de champ ayant sa grille connectée à ladite ligne de sortie et, d'autre part, à la base d'un transistor bipolaire ayant son émetteur relié au potentiel de référence et son collecteur relié à ladite ligne de sortie.

Les caractéristiques et avantages de l'invention ressortent clairement de la description qui suit, donnée à titre d'exemple et faite en référence aux dessins annexés.

Dans les dessins :
- la figure 1 illustre schématiquement et partiellement une mémoire morte incluant un réseau logique programmable conforme à l'invention ;
- la figure 2 est une vue de détail agrandi d'un point de programmation du réseau logique programmable représenté sur la figure 1 ; et
- la figure 3 illustre schématiquement et partiellement un circuit PLA incluant un réseau logique programmable conforme à l'invention.

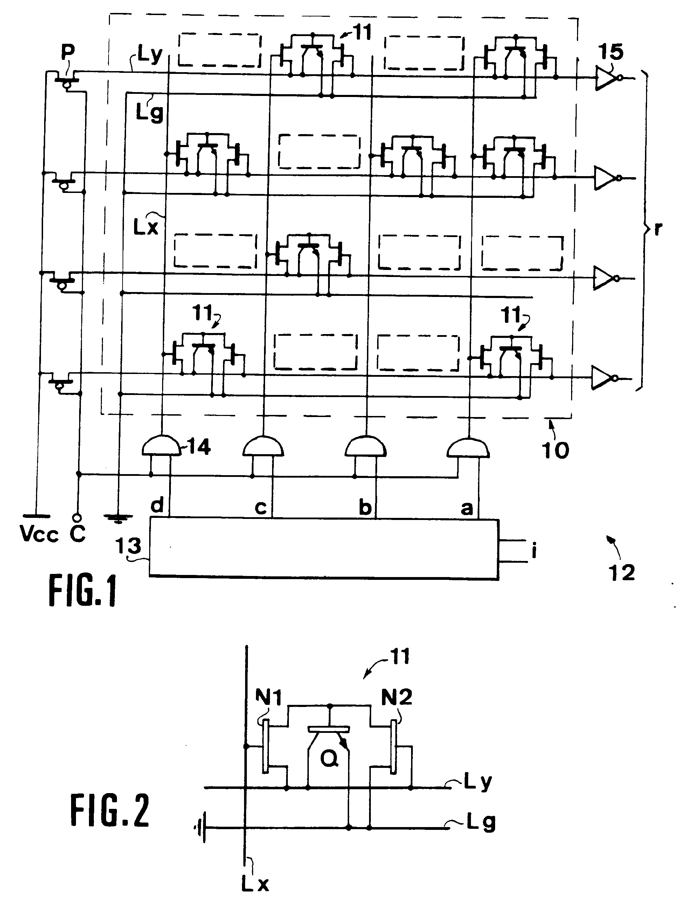

La figure 1 illustre de façon schématique et très simplifiée un exemple de réseau logique programmable 10. De manière classique, le réseau 10 est une matrice ou grille faite de lignes d'entrée Lx se croisant avec des lignes de sortie Ly par l'intermédiaire de points de programmation 11. Les points de programmation établissent chacun la liaison désirée ou programmée entre une ligne d'entrée et une ligne de sortie pour remplir une fonction logique déterminée. Dans la figure 1, l'absence d'un point de programmation 11 entre une ligne d'entrée Lx et une ligne de sortie Ly est simplement indiquée par un rectangle représenté par un trait tireté. De manière classique également, les points de programmation 11 sont connectés à un potentiel de référence, la masse par exemple, par l'intermédiaire d'une ligne de masse Lg.

Selon l'invention, chaque point de programmation 11 a la structure représentée sur la figure 1 et de façon plus nette sur la figure 2. En référence à la figure 2, il apparaît que chaque point de programmation 11 entre une ligne d'entrée Lx et une ligne de sortie Ly du réseau 10 se compose de deux transistors à effet de champ N1, N2 et d'un transistor bipolaire Q. Les transistors à effet de champ employés sont à canal n à enrichissement, du type MOS, et le transistor bipolaire Q est du type n. Plus précisément, le transistor N1 a sa grille connectée à la ligne d'entrée Lx et son drain connecté à la ligne de sortie Ly. La source du transistor N1 est reliée à la ligne de masse Lg par l'intermédiaire du trajet drain-source du transistor N2 ayant sa grille connectée à la ligne de sortie Ly. Le transistor bipolaire Q a son collecteur connecté à la ligne de sortie Ly, son émetteur connecté à la ligne de masse Lg et sa base connectée au point de jonction de la source du transistor N1 avec le drain du transistor N2. Le fonctionnement des points de programmation 11 dans un réseau logique programmable 10 conforme à l'invention ressortira de la description du dispositif représenté sur la figure 1.

Dans la figure 1, le réseau 10 conforme à l'invention constitue la partie essentielle d'une mémoire morte 12, réalisée dans un environnement BiCMOS. La lecture de la mémoire morte se fait par l'application d'un signal d'entrée i et par la réception du signal de sortie r. De manière classique, le signal d'entrée i est appliqué à un décodeur 13 délivrant, dans l'exemple illustré, quatre bits d'entrée a, b, c, d. La mémoire 12 illustrée reçoit aussi le signal de commande de précharge C. Chaque ligne d'entrée Lx du réseau 10 est connectée à la sortie d'une porte ET 14 ayant une entrée recevant le signal de commande de précharge C et une seconde entrée recevant un bit d'entrée respectif a-d fourni par le décodeur 13. Enfin, la mémoire morte 12 reçoit deux potentiels d'alimentation, à savoir la masse appliquée aux lignes de masse Lg du réseau 10, et le potentiel Vcc, + 5 volts par exemple. Chaque ligne de sortie Ly du réseau 10 est connectée à la source d'un transistor à effet de champ P à canal p à enrichissement. Chaque transistor P a son drain connecté au potentiel Vcc et a sa grille recevant le signal de commande de précharge C. Le signal de sortie r de la mémoire morte 12 est délivré par des inverseurs 15 appliqués chacun sur une ligne de sortie Ly.

Le fonctionnement de la mémoire 12 est analogue à une mémoire classique. Dans une mémoire classique, chaque point de programmation n'a que le transistor N1 illustré dans la figure 2, dont la source est connectée directement à la ligne de masse Lg. Le fonctionnement qui va être décrit comprend de manière classique une phase de précharge, suivie d'une phase d'évaluation. Ces phases sont déclenchées par des signaux de phase non illustrés, qui commandent l'état du signal de précharge C. Dans la phase de précharge, le signal de précharge C a la valeur logique "0" correspondant au potentiel de la masse. Le signal de précharge C commande d'une part la conduction des transistors P, qui mettent les lignes de sortie Ly au potentiel Vcc. D'autre part, le signal de précharge C appliqué sur les portes ET 14 met toutes les lignes d'entrée Lx à l'état logique "0". Dans ces conditions, dans chaque point de programmation 11 le transistor N1 est bloqué et le transistor N2 conduit. La conduction du transistor N2 permet de décharger la base du transistor bipolaire Q par l'intermédiaire de la ligne de masse Lg. Lorsque la phase d'évaluation est déclenchée, le signal de précharge C prend la valeur logique "1". Dans ces conditions, les transistors P ne conduisent plus et les portes ET 14 transmettent les bits d'entrée a-d sur les lignes d'entrée respectives Lx. Considérons par exemple le bit d'entrée a fourni par le décodeur 13, et supposons qu'il a la valeur logique "0". La ligne d'entrée Lx correspondante garde la valeur logique "0" de la phase de précharge et maintient donc l'état des points de programmation 11 connectés sur la ligne Lx. Les lignes de sortie correspondantes Ly conservent leur potentiel de précharge. Supposons maintenant que le bit d'entrée a sur la ligne d'entré Lx a la valeur logique "1". Dans chaque point de programmation 11 associé à la ligne Lx, le transistor N1 est rendu conducteur et provoque rapidement la conduction du transistor bipolaire. Le transistor N2 est bloqué. La ligne de sortie préchargée Ly associée au point de programmation 11 se décharge à travers le transistor bipolaire Q. Le fonctionnement relatif au bit d'entrée a est évidemment transposable aux autres bits d'entrée b, c et d fournis par le décodeur 13.

Un premier avantage de l'invention consiste en la décharge rapide d'une ligne de sortie Ly à travers le transistor bipolaire Q d'un point de programmation. Un autre avantage de l'invention se rapporte aux transistors à effet de champ de chaque point de programmation. Il a été expliqué précédemment que le transistor à effet de champ constituant chaque point de programmation d'un réseau logique programmable classique a une petite taille pour ne pas accroître la capacité des lignes. Cependant, le fonctionnement du réseau est ralenti à cause des petits transistors. Grâce à l'invention, la rapidité du réseau logique programmable est obtenue avec de petits transistors à effet de champ. Le transistor N1 commande seulement la conduction du transistor bipolaire Q, qui effectue la décharge. Le transistor N2 sert à la décharge de la capacité de base du transistor bipolaire Q. Par conséquent, chaque ligne d'entrée Lx conserve une capacité minimale dans un réseau logique programmable conforme à l'invention. Il en résulte un temps de commutation réduit de chaque ligne d'entré Lx en fonction des bits d'entrée a-d délivrés par le décodeur 13. D'une manière générale, le facteur de rapidité d'un réseau logique programmable conforme à l'invention est en moyenne de deux et peut atteindre une valeur double par rapport à une mémoire classique 12 n'ayant que le transistor N1 dans chaque point de programmation.

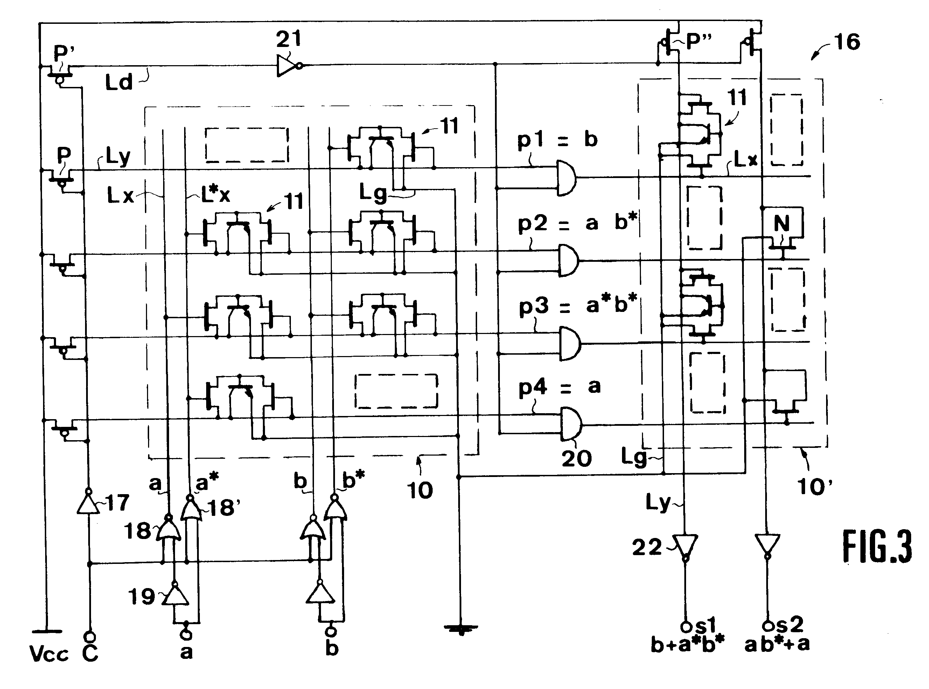

Il est clair cependant que la présence des deux transistors additionnels Q et N2 dans chaque point de programmation 11 se fait au détriment de la densité d'intégration de la mémoire 12. L'invention s'appliquera donc avantageusement à la fabrication de mémoires mortes 12 dans le but principal de conférer une grande rapidité aux circuits qui les exploitent. La description qui va suivre du dispositif représenté sur la figure 3 met bien en relief tous les avantages que l'on peut tirer des caractéristiques d'un réseau logique programmable 10 conforme à l 'invention.

La figure 3 illustre deux réseaux logiques programmables 10, 10′ conformes à l'invention, assemblés pour constituer un circuit PLA 16. Le circuit 16 illustré est un PLA autophasé conçu en technologie BiCMOS, tel que celui décrit dans l'article de Jim Sutton intitulé "80C 86 CMOS design from the NMOS architecture" dans la revue VLSI DESIGN de décembre 1983 pages 56-63. Pour la commodité des dessins, les réseaux logiques 10, 10′ ont une taille très réduite. Le réseau 10 conforme à l'invention est similaire au réseau 10 qui vient d'être décrit en référence aux figures 1 et 2. D'une manière générale, les éléments communs au circuit PLA 16 de la figure 3 et au réseau 10 de la figure 1 sont désignés par les mêmes chiffre de référence. En particulier, on notera que les lignes de masse Lg sont appliquées à la borne de masse d'entrée du circuit PLA 16. Le potentiel Vcc (+ 5 volts par exemple) est appliqué sur les drains d'une pluralité de transistors à effet de champ P à canal p à enrichissement. Chaque ligne de sortie Ly du réseau 10 est connectée à la source d'un transistor P correspondant. Le circuit PLA 16 reçoit aussi un signal de commande de précharge C appliqué aux grilles des transistors P par l'intermédiaire d'un inverseur 17. Dans le réseau 10, chaque ligne d'entrée Lx est associée à une ligne d'entrée complémentaire L*x représentative de la valeur logique inversée d'un même bit d'entrée. Seulement deux bits d'entrée a, b issus d'un signal d'entrée sont illustrés pour la commodité des dessins. Chaque couple de lignes d'entrée Lx, L*x est connecté à la sortie correspondante de deux portes NOR 18, 18′ à deux entrées, dont une entrée est connectée pour recevoir le signal de commande de précharge C. Chaque bit d'entrée a, b est appliqué par l'intermédiaire d'un inverseur 19 sur la seconde entrée de la porte NOR 18, et est appliqué directement sur la seconde entrée de la porte NOR 18′. Enfin, un transistor additionnel P′ a sa grille connectée à la sortie de l'inverseur 17 recevant le signal de précharge C, son drain appliqué sur le potentiel Vcc et sa source connectée sur une ligne factice (dummy line) Ld. Les quatre lignes de sortie Ly illustrées dans le réseau 10 fournissent les produits logiques respectifs p1-p4 en fonction de la position des points de programmation 11 et de leur connexion dans le réseau 10. Certains points de programmation 11 sont attachés à une ligne d'entrée Lx et d'autres points 11 sont attachés à la ligne d'entrée L*x. Le fonctionnement des points de programmation 11 du réseau 10 dans le circuit PLA 16 est identique à celui décrit en référence aux figures 1 et 2. Dans l'exemple illustré, p1 = b, p2 = ab*, p3 = a*b* et p4 = a.

Dans le circuit PLA 16, l'interface entre le réseau 10 de la matrice ET et le réseau 10′ de la matrice OU est faite de portes ET 20 à deux entrées, une entrée étant connectée à une ligne de sortie Ly correspondante du réseau 10 et l'autre entrée étant connectée à la ligne Ld par l'intermédiaire d'un inverseur 21. Les sorties des portes ET 20 sont connectées aux lignes d'entrée respectives Lx du réseau 10′. Chacune des deux lignes de sortie Ly du réseau 10′ est connectée à la source d'un transistor P˝ ayant son drain connecté au potentiel Vcc et sa grille commandée par la sortie de l'inverseur 21 dans la ligne Ld. Les deux lignes de sortie illustrées Ly du réseau 10′ fournissent à la sortie d'inverseurs respectifs 22 les deux signaux de sortie s1, s2. Les points de programmation 11 sont rattachés aux lignes de masse Lg. Pour la commodité des dessins, le réseau 10′ inclut deux variantes de réalisation des points de programmation 11. Les points de programmation 11 fournissant le signal s1 sont identiques à celui illustré dans la figure 2. Dans leur agencement illustré, le signal s1 = b + a*b*. En liaison avec la ligne de sortie fournissant le signal s2, les points de programmation 11 sont de type classique, n'incorporant qu'un seul transistor N équivalant au transistor N1 d'un point de programmation 11 conforme à l 'invention. Dans l 'agencement illustré le signal s2 = ab* + a.

On a vu en référence à la figure 1 que le réseau 10 conforme à l'invention, qui constitue la matrice ET du circuit PLA 16 dans la figure 3, a un fonctionnement très rapide par rapport à un réseau classique n'utilisant qu'un seul transistor MOS dans un point de programmation. Le premier avantage de l'invention est donc d'offrir une matrice ET très rapide comme matrice d'entrée du circuit PLA 16. L'ensemble du circuit PLA 16 peut être très rapide si le réseau 10′ de la matrice OU est aussi fait conformément à l'invention. Cependant, même avec un réseau 10′ classique, fait comme indiqué en liaison avec le signal de sortie s2 de la figure 3, le circuit PLA 16 restera très performant. On obtient alors un bon compromis entre le surcroît de place dans la matrice ET et la rapidité du circuit PLA 16.

En conclusion, un réseau logique programmable conforme à l 'invention présente les avantages suivants : il minimise la capacité des lignes d'entrée Lx pour obtenir une commutation rapide des potentiels de ces lignes en fonction de la valeur des signaux d'entrée ; il décharge rapidement les lignes de sortie Ly, qui peuvent donc avoir une capacité relativement élevée ; il ne consomme pas d'énergie statique ; et il peut s'appliquer dans de nombreuses variantes de réalisation et de fonctionnement. Par exemple, le réseau peut être commandé par divers signaux de phase, avec ou sans ligne factice Ld.

## Revendications

1. Réseau logique programmable intégré (10), comprenant des lignes d'entrée (Lx) se croisant avec des lignes de sortie (Ly), un couplage pouvant être établi entre une ligne d'entrée (Lx) et une ligne de sortie (Ly) par l'intermédiaire de points de programmation (11) incluant chacun un transistor à effet de champ (N1) ayant sa grille et son drain respectivement connectés à une ligne d'entrée (Lx) et à une ligne de sortie (Ly) et sa source reliée à un potentiel de référence (Lg), caractérisé en ce que dans chaque point de programmation (11) la source du premier transistor à effet de champ (N1) est reliée, d'une part, au potentiel de référence par l'intermédiaire du trajet drain-source d'un second transistor à effet de champ (N2) ayant sa grille connectée à ladite ligne de sortie (Ly) et, d'autre part, à la base d'un transistor bipolaire (Q) ayant son émetteur relié au potentiel de référence (Lg) et son collecteur relié à ladite ligne de sortie (Ly).

2. Réseau selon la revendication 1, caractérisé en ce qu'il est incorporé dans une mémoire morte (12).

3. Réseau selon la revendication 1, caractérisé en ce qu'il constitue au moins l'une des deux matrices (ET, OU) d'un circuit PLA (16).

## Patentansprüche

1. Integrierte programmierbare Logikanordnung (10) mit Eingangsleitungen (Lx), die sich mit Ausgangsleitungen (Ly) kreuzen, wobei eine Kopplung zwischen einer Eingangsleitung (Lx) und einer Ausgangsleitung (Ly) über Programmierpunkte (11) erzeugt werden kann, die jeweils einen Feldeffekttransistor (N1) enthalten, dessen Gate-Anschluß und dessen Drain-Anschluß an eine Eingangsleitung (Lx) bzw. eine Ausgangsleitung (Ly) angeschlossen sind, während sein Source-Anschluß an ein Referenzpotential (Lg) gelegt ist, dadurch gekennzeichnet, daß in jedem Programmierpunkt (11) der Source-Anschluß des ersten Feldeffekttransistors (N1) einerseits über die Drain-Source-Strecke eines zweiten Feldeffekttransistors (N2), dessen Gate-Anschluß an die Ausgangsleitung (Ly) angeschlossen ist, an das Referenzpotential und andererseits an die Basis eines bipolaren Transistors (Q) angeschlossen ist, dessen Emitter an das Referenzpotential (Lg) gelegt ist und dessen Kollektor an die Ausgangsleitung (Ly) angeschlossen ist.

2. Anordnung nach Anspruch 1, dadurch gekennzeichnet, daß sie in einem Festspeicher (12) enthalten ist.

3. Anordnung nach Anspruch 1, dadurch gekennzeichnet, daß sie wenigstens eine der zwei Matrizen (ET, OU) einer PLA-Schaltung (16) bildet.

## Claims

1. An integrated programmable logic network (10), comprising input lines (Lx) intersecting with output lines (Ly), a connection being able to be established between one input line (Lx) and one output line (Ly) by the intermediary of programming points (11) each including a field effect transistor (N1) having its gate and its drain respectively connected to one input line (Lx) and one output line (Ly) and its source connected to a reference potential (Lg), characterised in that in each programming point (11) the source of the first field effect transistor (N1) is connected, on one hand, to the reference potential by the intermediary of the drain-source path of a second field effect transistor (N2) having its gate connected to said output line (Ly) and, on the other hand, to the base of a bipolar transistor (Q) having its emitter connected to the reference potential (Lg) and its collector connected to said output line (Ly).

2. A network as claimed in claim 1, characterised in that it is incorporated into a read only memory (12).

3. A network as claimed in claim 1, characterised in that it constitutes at least one of the two matrices (AND, OR) of a PLA circuit (16).
